# FASCICULE DE BREVET EUROPEEN

(11) **EP 1 234 360 B1**
(45) Date de publication et mention de la délivrance du brevet: **02.07.2003**
(21) Numéro de dépôt: 01907659.5
(22) Date de dépôt: 19.01.2001
(51) Int. Cl.: H01S 5/14

(54) **PROCEDE ET DISPOSITIF DE COMMUTATION EN LONGUEUR D'ONDE D'UNE SOURCE LASER**
VERFAHREN UND VORRICHTUNG ZUR WELLENLÄNGENUMSCHALTUNG EINER LASERQUELLE
METHOD AND DEVICE FOR WAVELENGTH SWITCHING OF A LASER SOURCE

(30) Priorité: 26.01.2000 FR 0001016
(43) Date de publication de la demande: 28.08.2002
(73) Titulaire: FRANCE TELECOM, 75015 Paris (FR)
(72) Inventeur: CHANCLOU, Philippe, F-22700 Louannec (FR); THUAL, Monique, F-22560 Trebeurden (FR); GADONNA, Michel, F-22300 Lannion (FR); LAURENT, Arnaud, F-22730 Tregastel (FR)
(74) Mandataire: Jeune, Pascale
(86) Numéro de dépôt international: FR0100196
(87) Numéro de publication internationale: WO01056123

(56) Documents cités:
- EP-A- 0 798 830
- EP-A- 0 930 679
- US-A- 5 859 945
- CHANCLOU P ET AL: "HIGHLY EFFICIENT COLLECTIVE COUPLING BETWEEN LASER DIODE ARRAY AND LENSED FIBRE RIBBON" ELECTRONICS LETTERS,GB,IEE STEVENAGE, vol. 34, no. 3, 5 février 1998 (1998-02-05), pages 273-274, XP000773724 ISSN: 0013-5194
- LAURENT A ET AL: "Double external cavity laser diode for DWDM application" JOURNAL OF OPTICS A: PURE AND APPLIED OPTICS, JAN. 2000, IOP PUBLISHING, UK, vol. 2, no. 1, pages L6-L8, XP002150952 ISSN: 1464-4258

## Description

La présente invention se rapporte à un procédé et à un dispositif de commutation en longueur d'onde d'une source laser.

L'invention s'inscrit dans le domaine du multiplexage en longueur d'onde qui permet de démultiplier la capacité d'une infrastructure de transmission sur fibre optique.

L'invention trouve une application très avantageuse en ce qu'elle permet, par le remplacement de la source laser d'extrémité, de simplifier la maintenance d'une infrastructure à fibre optique existante lorsque la transmission sur la fibre optique met en oeuvre des techniques de multiplexage en longueur d'onde qui nécessitent des sources laser multi longueurs d'onde. Parmi ces techniques de multiplexage, les techniques connues sous les sigles anglo-saxons DWDM, abréviation des termes anglo-saxons Dense Wavelength Division Multiplexing, sont en cours de déploiement sur des liaisons transatlantiques qui supportent de gros débits dont une part peut être liée à l'utilisation du réseau Internet. Etant donné la demande fortement croissante d'utilisation de ce réseau, la simplification de la maintenance effectuée à distance de l'infrastructure optique, par le seul remplacement de la source laser d'extrémité, représente un atout majeur.

Actuellement, les sources laser d'extrémité compatibles avec une distribution multi longueurs d'onde peuvent être de différents types.

Un premier type est dit DFB ou DBR, abréviation des termes anglo-saxons Distributed Feedback ou Distributed Bragg Reflector. Une telle source sélectionne la longueur d'onde au moyen d'un élément de sélection situé dans la même structure que le milieu amplificateur.

Un deuxième type comprend les sources laser à cavité externe délimitée par un réseau de Bragg photoinscrit dans une fibre optique. La demande de brevet européen 0 930 679 décrit une telle source laser qui comprend un milieu amplificateur et un certain nombre de réseaux de Bragg photoinscrits dans une même fibre optique; chacun des réseaux de Bragg coopérant avec le milieu amplificateur pour déterminer une cavité externe et une longueur d'onde. Dans cette source laser la commutation de longueur d'onde est effectuée en sélectionnant, au moyen d'un filtre sélectif inséré entre le milieu amplificateur et la fibre optique, une longueur d'onde parmi les longueurs d'onde présentes dans les cavités.

Dans le cas des sources laser DFB ou DBR la dépendance à la température est de l'ordre de 100pm/K. Par conséquent, l'utilisation des sources DFB ou DBR est contraignante étant donné la nécessité de les réguler en température au moyen d'un élément Peltier pour assurer une stabilité fréquentielle. Par contre, dans le cas des sources laser à cavité externe dans lesquelles le réseau est photoinscript dans de la silice, la longueur d'onde de Bragg a l'avantage d'être faiblement sensible à la température, de l'ordre de 15pm/K.

Toutefois, dans cette source à cavité externe connue les longueurs d'onde existent simultanément sur une même fibre optique en l'absence du filtre, et par conséquent l'accord du filtre doit être effectué précisément sur la longueur d'onde à sélectionner. Par conséquent, il est nécessaire de contrôler la température pour maintenir l'accord du fait de la dérive du filtre avec la température.

Aussi, le problème technique à résoudre par l'objet de la présente invention est de proposer un procédé de commutation en longueur d'onde, d'une source laser comprenant une cavité externe à réseau de Bragg sur fibre optique, qui effectue une commutation de longueur d'onde moins sensible à la température ; c'est à dire sans utilisation d'élément accordable en longueur d'onde sensible à la température.

Une solution au problème technique posé consiste, selon la présente invention, en ce que ledit procédé consiste :
- à commuter de manière spatiale dans la cavité externe une pluralité de fibres optiques portant chacune un réseau de Bragg différent.

En outre, l'invention a pour objet un dispositif de commutation en longueur d'onde d'une source laser comprenant une cavité externe à réseau de Bragg sur fibre optique. Ledit dispositif comprend :
- un commutateur spatial pour commuter dans la cavité externe une pluralité de fibres optiques portant chacune un réseau de Bragg différent.

Ainsi, le procédé selon l'invention, qui concerne une source laser à cavité externe constituée d'une part par un milieu amplificateur et d'autre part par un réseau de Bragg, commute la longueur d'onde en modifiant la cavité externe par substitution du réseau de Bragg par un autre réseau de Bragg ; ce dernier réseau de Bragg ayant un pas différent du précédent réseau de Bragg. La substitution est effectuée en commutant de manière spatiale dans la cavité externe les fibres optiques qui contiennent chacune un réseau de Bragg.

Le procédé et le dispositif de commutation en longueur d'onde d'une source laser conformes à l'invention résolvent le problème posé. En effet, à l'issue de la commutation effectuée de manière spatiale, la présence d'une seule longueur d'onde à la fois, en sortie de la fibre optique en regard du milieu amplificateur, ne nécessite pas de filtrage ; un élément accordable en longueur d'onde n'est pas nécessaire. Par conséquent, la commutation de longueur d'onde peut être effectuée sans contrôle de la température et, de manière avantageuse, l'écart entre les longueurs d'onde n'est pas limité par la sélectivité d'un filtre.

En outre, le procédé et le dispositif selon l'invention permettent de disposer d'une émission laser mono ou multi voies suivant que la source laser comprend un seul ou une pluralité de milieux amplificateurs.

Par ailleurs, le couplage entre les fibres optiques et le milieu amplificateur peut être adapté en fonction d'exigences particulières. Pour éloigner le commutateur spatial du milieu amplificateur, le milieu amplificateur peut être couplé aux fibres optiques au moyen d'une fibre optique mono mode intermédiaire. Cette fibre optique intermédiaire peut être équipée d'une lentille pour optimiser les caractéristiques d'émission et améliorer le couplage. En outre, pour limiter les perturbations lors du fonctionnement, les extrémités en regard des fibres optiques peuvent être équipées d'un moyen de couplage tel qu'une micro optique.

D'autres caractéristiques et avantages de l'invention apparaîtront lors de la description qui suit faite en regard de figures annexées données à titre d'exemples non limitatifs.

La figure 1 est un schéma d'une réalisation particulière d'un dispositif de commutation mono voie selon l'invention.

La figure 2 est un schéma d'une réalisation particulière d'un dispositif de commutation multi voies selon l'invention.

La figure 3 est un schéma d'une réalisation particulière d'un dispositif de commutation multi voies selon l'invention en configuration réflexion.

Les figures 4 à 7 sont des schémas de modes particuliers de couplage des fibres optiques.

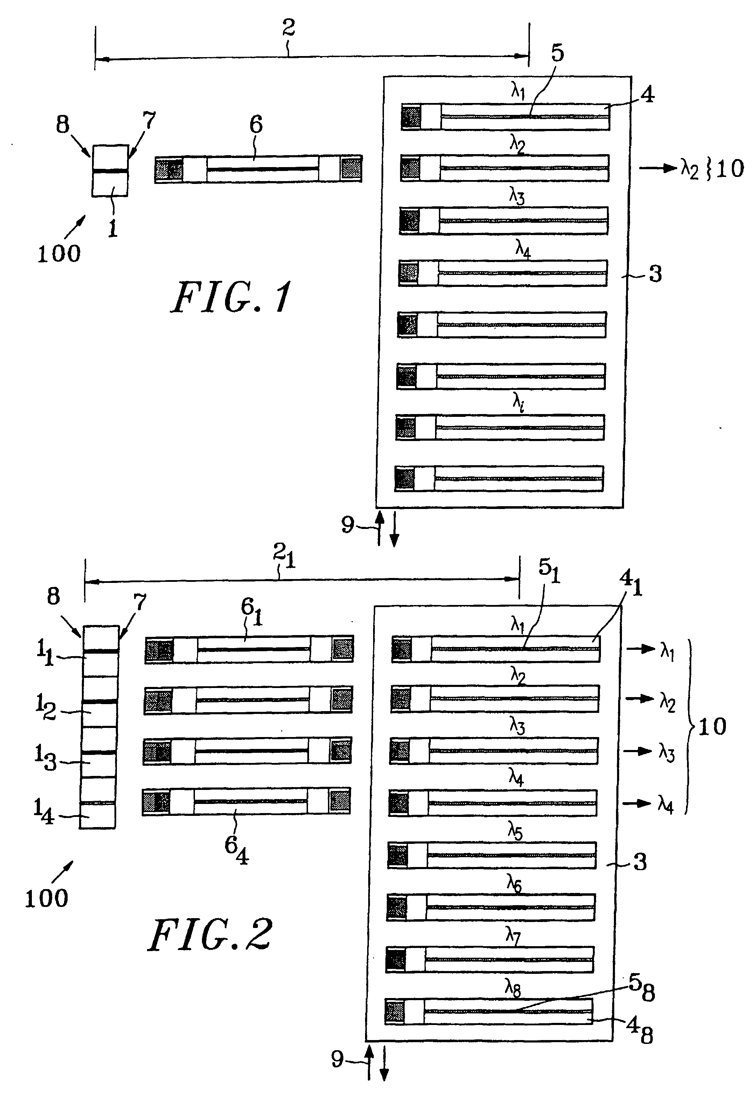

La figure 1 représente schématiquement une réalisation particulière d'un dispositif de commutation d'une source laser 100 selon l'invention. Le dispositif comprend un milieu amplificateur 1, une cavité externe 2, un commutateur spatial 3 et des fibres optiques 4 portants des réseaux de Bragg 5. La réalisation est particulière en ce que le dispositif comprend en outre une fibre optique intermédiaire 6.

Le milieu amplificateur 1 comprend habituellement, entre deux faces, une diode laser. Une des faces, dite face avant 7, est traitée pour en diminuer la réflectivité. Le traitement peut consister en un dépôt de couches diélectriques. La face traitée 7 est située du coté des réseaux de Bragg 5. L'autre face, dite face arrière 8, est non traitée ou traitée pour être réfléchissante comme un miroir.

La cavité externe 2 est délimitée par la face arrière 8, et par un des réseaux de Bragg 5.

Le commutateur spatial 3 permet de commuter la pluralité des fibres optiques 4 devant le milieu amplificateur 1 dans la cavité externe 2. Un exemple de commutation spatiale consiste à déplacer les fibres optiques 4 en translation devant le milieu amplificateur 1 pour positionner une des fibres optiques 4 en regard du milieu amplificateur 1. La translation est effectuée suivant un premier et un second sens indiqués par les flèches 9. Le commutateur spatial 1 peut faire appel à un actionneur thermique, à une attraction électromagnétique ou à tout autre moyen de commutation spatial connu.

Chaque fibre optique 4, installée sur le commutateur spatial 3, est une fibre optique mono mode dans laquelle est photoinscrit un réseau de Bragg 5.

Chaque réseau de Bragg 5 a un pas donné qui détermine une longueur d'onde. Le nombre de réseaux de Bragg 5 de pas différents détermine le nombre de longueurs d'onde différentes qui peuvent être commutées.

Selon cette réalisation particulière de l'invention, une fibre optique intermédiaire 6 est disposée entre le milieu amplificateur 1 et le commutateur spatial 3 pour assurer le couplage entre le milieu amplificateur 1 et le commutateur spatial 3. La fibre optique intermédiaire 6 facilite le positionnement du commutateur spatial 3 devant le milieu amplificateur 1 et elle 6 permet d'éloigner le commutateur 3 du milieu amplificateur 1. La fibre optique intermédiaire 6 est mono mode, elle peut être équipée d'une lentille pour optimiser les caractéristiques d'émission et améliorer le couplage et, en outre, la lentille peut avoir un profil hyperbolique. En particulier, l'association d'un profil hyperbolique et d'une lentille à gradient d'indice, du type de celui décrit dans le brevet FR2752623 délivré au nom de la Demanderesse et décrit ci-après, permet d'éloigner la fibre optique intermédiaire 6 à une grande distance du milieu amplificateur 1, par exemple 60µm.

Suivant l'illustration, le commutateur 3 est positionné de telle manière que le réseau de Bragg 5 qui correspond à la longueur λ₂ délimite la cavité externe. Suivant cette configuration l'émission en sortie 10 du dispositif a une longueur d'onde λ₂.

Le dispositif représenté à la figure 1 est mono voie car la source laser 100 comprend un seul milieu amplificateur 1 ; soit une seule cavité externe 2. Par conséquent, le dispositif émet un seul faisceau laser à une longueur d'onde donnée.

La figure 2 représente une réalisation particulière d'un dispositif de commutation multivoies. Un dispositif multivoies permet l'émission simultanée de plusieurs faisceaux laser de longueurs d'onde différentes. Le nombre de faisceaux émis est déterminé par le nombre de milieux amplificateurs que comprend la source laser 100, sous condition que le nombre de fibres optiques soit supérieur ou égal au nombre de milieux amplificateurs. Chaque milieu amplificateur 1 constitue, avec un réseau de Bragg 5, une cavité externe 2. Dans l'exemple illustré par la figure 2, la source laser 100 comprend quatre milieux amplificateurs 1ᵢ, i=1 à 4, et huit fibres optiques 4ᵢ, i=1 à 8. Le nombre de faisceaux laser de sortie 10 est égal au nombre de milieux amplificateurs, soit quatre. Chaque fibre optique 4ᵢ comprend un réseau de Bragg 5ᵢ qui détermine une longueur d'onde λᵢ, i=1 à 8. Suivant l'exemple, les longueurs d'onde associées aux réseaux de Bragg sont λ₁, λ₂, λ₃, λ₄ λ₅, λ₆, λ₇, et λ₈ et le commutateur 3 est positionné de telle manière que les faisceaux laser de sortie ont pour longueur d'onde d'émission λ₁, λ₂, λ₃, et λ₄. La commutation des fibres optiques 4ᵢ permet de modifier les longueurs d'onde de sortie. Par exemple, en commutant quatre fois la pluralité des fibres optiques 4ᵢ, les faisceaux laser de sortie ont pour longueur d'onde d'émission respectivement λ₅, λ₆, λ₇, et λ₈.

La réalisation est particulière en ce que le dispositif comprend en outre une fibre optique intermédiaire 6ᵢ entre les milieux amplificateurs et les fibres optiques ; chaque fibre optique intermédiaire remplissant la même fonction que la fibre optique intermédiaire du précédent dispositif.

La description du dispositif faite en regard des figures 1 et 2, correspond à un dispositif en configuration transmission. C'est-à-dire que les sorties 10 du dispositif sont du même côté que les fibres optiques 4 par rapport au milieu amplificateur 1. En d'autres termes, les sorties 10 du dispositif sont du même côté que la face avant 7 des milieux amplificateurs 1.

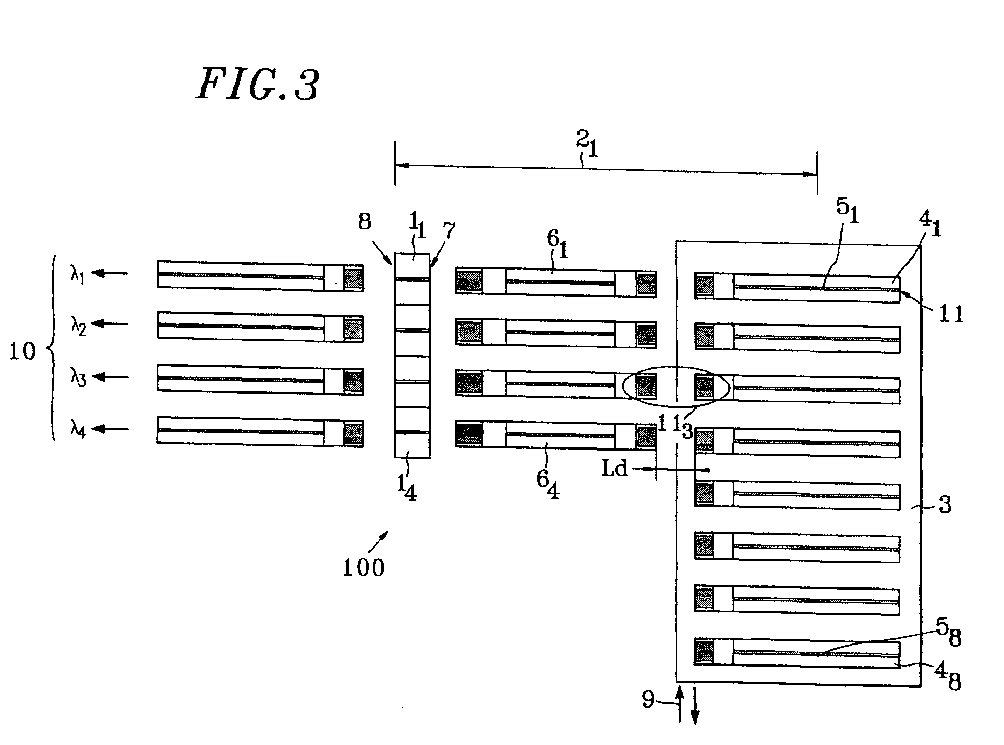

La figure 3 est un schéma d'un dispositif de commutation selon l'invention en configuration réflexion. Selon cette configuration, les sorties 10 du dispositif sont du côté opposé aux fibres optiques 4ᵢ par rapport aux milieux amplificateurs 1ᵢ. En d'autres termes, les sorties 10 du dispositif sont du même côté que la face arrière 8 de chaque milieu amplificateur 1ᵢ. Dans cette configuration, la réflectivité des dioptres 11 de sortie des fibres optiques 4ᵢ comprenant un réseau de Bragg 5ᵢ peut être limitée par un traitement particulier. Ce traitement peut consister en un clivage de la fibre optique, en un polissage en biais de la fibre optique par exemple de 12° ou en l'insertion d'un gel d'indice. Ces traitements sont connus de l'homme du métier.

Les performances des sources lasers à cavité externe sont fortement liées au rapport des gains de seuil, respectivement de la diode laser et de la cavité externe. Or, la cavité parasite formée entre les extrémités des fibres optiques perturbe la cavité externe car elle est insérée entre la face avant du milieu amplificateur et le réseau de Bragg. Une contre réaction importante sur ces extrémités de fibres optiques contribue à augmenter le gain de seuil de la cavité externe et donc contribue à favoriser l'oscillation laser sur la diode laser. Cette compétition entre mode laser de la diode et mode laser de la cavité externe peut provoquer une brusque élévation du bruit de la source laser, si les gains de seuil deviennent proches. Et, en outre, elle peut réduire fortement le taux de suppression des modes latéraux.

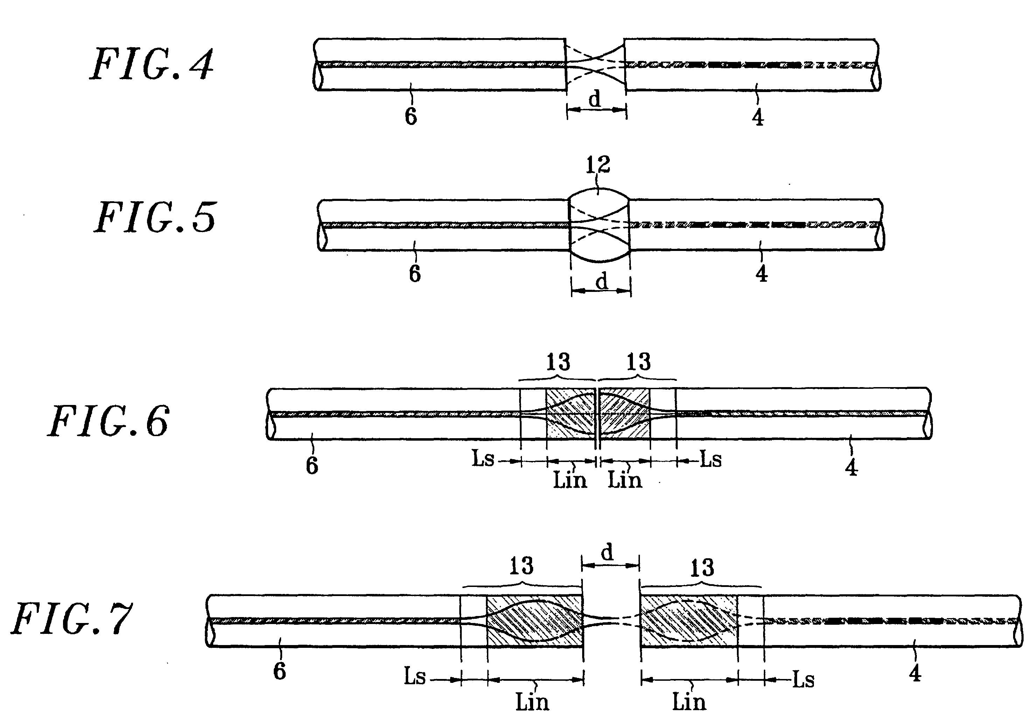

En effet, la cavité parasite peut, en fonction des pertes de couplage, de sa longueur, de la forme dioptrique et des indices des milieux intervenants, perturber l'émission laser. En particulier, ceci peut se traduire par une augmentation du bruit d'intensité relatif noté RIN, abréviation des termes anglo-saxons Relative Intensity Noise, et une diminution du taux de suppression des modes latéraux. Ainsi, le couplage est déterminé pour élargir la taille du mode et/ou allonger la longueur de la cavité parasite. D'une part, plus la taille du mode est grande, plus les contraintes d'alignement entre les deux fibres optiques peuvent être relâchées. D'autre part, l'allongement de la cavité parasite permet de minimiser la contre-réaction optique qui perturbe le fonctionnement d'une source laser à cavité externe. Différents modes de réalisation de couplage pour la mise en oeuvre de l'invention sont décrits ci-après en regard des figures 4 à 7.

Suivant un premier mode de réalisation, le couplage entre fibres optiques est effectué en clivant les fibres optiques. La figure 4 représente un couplage de ce type dans lequel les deux fibres optiques mono mode 6 et 4 sont clivées droites. La distance d entre les deux fibres optiques détermine la longueur de la cavité parasite. Cette longueur est de l'ordre de 20µm. Ce mode de réalisation a pour avantage d'être de fabrication simple.

Une amélioration des performances de couplage de ce mode de réalisation est obtenue avec une variante de réalisation. Elle est représentée à la figure 5. L'amélioration est obtenue par l'insertion d'un liquide 12 adaptateur d'indice entre les deux fibres optiques 6 et 4. En effet, le liquide 12 adaptateur d'indice limite l'influence de la cavité parasite de longueur d. Cette variante permet ainsi de relâcher les tolérances de positionnement transversal et permet d'améliorer les performances de couplage.

Suivant un second mode de réalisation illustré par les figures 6 et 7, le couplage entre fibres optiques 6 et 4 est effectué au moyen de fibres équipées de micros optiques 13 désignées par le terme « gradissimo ». Ces micros optiques 13 ont pour but d'adapter la taille des modes en extrémité des fibres optiques conformément aux caractéristiques de couplage recherchées. Leur principe repose sur l'insertion d'un premier tronçon de fibre, en silice pure de longueur Ls, et d'un second tronçon de fibre, à gradient d'indice de longueur Lin, en bout d'une fibre optique mono mode. Ces micros optiques 13 ne nécessitent pas l'usage d'un gel adaptateur d'indice, cependant elles peuvent être combinées avec l'insertion d'un tel gel en fonction des critères retenus (coûts, performances, ...). Une micro optique « gradissimo » est obtenue suivant un procédé qui consiste :
- à souder à l'aide d'une soudeuse collective un ruban de n fibres optiques multi modes à gradient d'indice, en abrégé « gradis », à un ruban de n fibres optiques de silice sans coeur, en abrégé si,
- à fracturer le ruban de n fibres optiques de silice sans coeur de manière à obtenir n tronçons parallèles de longueur 1,
- à souder un ruban de n fibres optiques mono mode, en abrégé « mo », aux tronçons de silice,
- à fracturer le ruban de manière à garder une longueur L de fibre optique multi modes à gradient d'indice dans le prolongement des tronçons de silice.

Le ruban obtenu comprend n micros optiques avec n supérieur ou égal à 1. Le ruban est désigné par le terme « gradissimo» abréviation de, gradient d'indice (gradis), silice (si) et mono mode (mo). Le procédé est plus précisément décrit dans le brevet français 2752623 délivré au nom de la Demanderesse.

Le couplage au moyen de micros optiques permet, avec une longueur Ls et une longueur Lin déterminées, d'augmenter la taille du mode comme illustrée par la figure 6. Ainsi, il est possible d'obtenir par exemple une taille du mode à l'extrémité de la fibre optique de 58µm, à comparer à la taille du mode à l'extrémité d'une fibre optique mono mode classique de 9,2µm. Une telle différence permet un relâchement significatif des tolérances de positionnement que ne permet pas le couplage avec une fibre optique mono mode classique. Suivant l'exemple, le désalignement transversal théorique correspondant à une perte de couplage de 3dB passe de, 7,5µm pour un couplage avec des fibres optiques mono mode classique à, 24µm pour un couplage avec des micros optiques.

L'allongement de la cavité parasite n'est pas efficace avec de simples fibres optiques mono mode. En effet, avec un tel couplage l'allongement entraîne une chute du taux de couplage et entraîne une augmentation rédhibitoire du gain de seuil de la source laser à cavité externe. Le couplage au moyen de micros optiques 13 permet d'allonger la longueur d de la cavité parasite comme illustrée sur la figure 7. Ainsi, un tel couplage permet d'optimiser les caractéristiques d'émission. C'est à dire qu'il permet d'obtenir un meilleur taux de suppression de modes et une plus grande stabilité devant le courant de polarisation comparativement au couplage par une fibre optique mono mode clivée droite. Le couplage au moyen de micros optiques donne des performances similaires à celles obtenues avec un couplage au moyen de fibres optiques mono modes plongées dans du liquide d'indice à courant équivalent (50mA). Mais le couplage au moyen de micros optiques est particulièrement avantageux en ce qu'il ne nécessite pas de liquide d'indice.

## Revendications

1. Procédé de commutation en longueur d'onde d'une source laser (100) comprenant une cavité externe (2, 2ᵢ) à réseau de Bragg (5, 5ᵢ) sur fibre optique (4, 4ᵢ) **caractérisé en ce que** ledit procédé consiste :
- à commuter de manière spatiale dans la cavité externe (2, 2ᵢ) une pluralité de fibres optiques (4, 4ᵢ) portant chacune un réseau de Bragg (5, 5ᵢ) différent.

2. Procédé de commutation en longueur d'onde d'une source laser (100) selon la revendication 1, **caractérisé en ce que** ledit procédé consiste également :
- à coupler le milieu amplificateur (1, 1ᵢ) qui délimite la cavité externe (2, 2ᵢ) aux fibres optiques (4, 4ᵢ), au moyen d'une fibre optique intermédiaire (6, 6ᵢ).

3. Procédé de commutation en longueur d'onde d'une source laser (100) selon la revendication 2, **caractérisé en ce que** ledit procédé consiste également :
- à délimiter une pluralité de cavités externes (2ᵢ) à réseau de Bragg (5ᵢ) au moyen d'une pluralité de milieux amplificateurs (1ᵢ) et
- à émettre simultanément un faisceau laser par cavité externe (2ᵢ).

4. Procédé de commutation en longueur d'onde d'une source laser (100) selon l'une des revendications 2 et 3, **caractérisé en ce que** ledit procédé consiste également :
- à coupler chaque fibre optique intermédiaire (6, 6ᵢ) avec les fibres optiques (4, 4ᵢ) portant les réseaux de Bragg (5, 5ᵢ), en équipant les bouts en regard des fibres optiques d'un tronçon en silice pur et d'un tronçon à gradient d'indice (13), lesdits tronçons étant de longueur déterminée (Ls, Lin).

5. Procédé de commutation en longueur d'onde d'une source laser (100) selon l'une des revendications 2 à 4, **caractérisé en ce que** ledit procédé consiste également :
- à insérer un liquide (12) adaptateur d'indice entre chaque fibre optique intermédiaire (6, 6ᵢ) et les fibres optiques (4, 4ᵢ) portant les réseaux de Bragg (5, 5ᵢ).

6. Dispositif de commutation en longueur d'onde d'une source laser (100) comprenant une cavité externe (2, 2ᵢ) à réseau de Bragg (5, 5ᵢ) sur fibre optique (6, 6ᵢ) **caractérisé en ce que** ledit dispositif comprend :
- un commutateur spatial (3) pour commuter dans la cavité externe (2, 2ᵢ) une pluralité de fibres optiques (6, 6ᵢ) portant chacune un réseau de Bragg (5, 5ᵢ) différent.

7. Dispositif de commutation en longueur d'onde d'une source laser (100) selon la revendication 6, **caractérisé en ce que** ledit dispositif comprend en outre :
- un milieu amplificateur (1, 1ᵢ) ayant une face avant (7) et une face arrière (8), la face arrière (8) délimitant avec un réseau de Bragg (5, 5ᵢ) la cavité externe (2, 2ᵢ) et
- une fibre optique (6, 6ᵢ) intermédiaire entre la face avant (7) du milieu amplificateur (1, 1ᵢ) et une fibre optique (4, 4ᵢ) portant un réseau de Bragg (5, 5ᵢ) pour coupler le milieu amplificateur (1, 1ᵢ) à la fibre optique (4, 4ᵢ) portant un réseau de Bragg (5, 5ᵢ).

8. Dispositif de commutation en longueur d'onde d'une source laser selon la revendication 7, **caractérisé en ce que** ledit dispositif comprend en outre :
- une pluralité de milieux amplificateurs (1ᵢ) délimitant une pluralité de cavités externes (2ᵢ) à réseau de Bragg (5ᵢ) sur fibre optique (4ᵢ), pour émettre simultanément des faisceaux laser sur des fibres optiques (4ᵢ) différentes et
- une pluralité de fibres optiques (6, 6ᵢ) intermédiaires, chaque fibre optique intermédiaire(6, 6ᵢ) couplant un milieu amplificateur (1, 1ᵢ) à une fibre optique (4, 4ᵢ) portant un réseau de Bragg (5, 5ᵢ).

9. Dispositif de commutation en longueur d'onde d'une source laser selon l'une des revendications 7 et 8 **caractérisé en ce que** ledit dispositif comprend en outre :
- un traitement limitant la réflectivité du dioptre (11) d'une des extrémités de chaque fibre optique (4, 4ᵢ) portant un réseau de Bragg (5, 5ᵢ), ladite extrémité étant du côté opposé à la fibre optique intermédiaire (6, 6i) et
- les faisceaux laser sont émis du côté de la face arrière (8) des milieux amplificateurs (1, 1ᵢ).

10. Dispositif de commutation en longueur d'onde d'une source laser selon l'une des revendications 7 à 9 **caractérisé en ce que** :
- chaque fibre optique intermédiaire (6, 6ᵢ) et chaque fibre optique (4, 4ᵢ) portant un réseau de Bragg (5, 5ᵢ) sont clivées.

11. Dispositif de commutation en longueur d'onde d'une source laser selon l'une des revendications 7 à 9 **caractérisé en ce que** :
- les extrémités en regard, de chaque fibre optique intermédiaire (6, 6ᵢ) et de chaque fibre optique (4, 4ᵢ) portant un réseau de Bragg (5, 5ᵢ), sont équipées d'une micro optique (13) composée d'un tronçon en silice pur et d'un tronçon à gradient d'indice, lesdits tronçons étant de longueur déterminée (Ls, Lin), pour coupler les fibres optiques (6ᵢ, 4ᵢ) entre elles.

12. Dispositif de commutation en longueur d'onde d'une source laser selon l'une des revendications 10 et 11 **caractérisé en ce que** ledit dispositif comprend en outre :
- un liquide (12) adaptateur d'indice entre chaque fibre optique intermédiaire (6, 6ᵢ) et une fibre optique (4, 4ᵢ) portant un réseau de Bragg (5, 5ᵢ).

13. Dispositif de commutation en longueur d'onde d'une source laser selon l'une des revendications 7 à 12 **caractérisé en ce que** :
- une des extrémités de chaque fibre optique intermédiaire (6, 6ᵢ) est équipée d'un tronçon en silice pur et d'un tronçon à gradient d'indice, lesdits tronçons étant de longueur déterminée, pour coupler la fibre optique intermédiaire (6, 6ᵢ) à un des milieux amplificateurs (1, 1ᵢ).

14. Dispositif de commutation en longueur d'onde d'une source laser selon la revendication 13 **caractérisé en ce que** :
- un profil hyperbolique est donné à l'extrémité de la fibre optique intermédiaire (6, 6ᵢ) en regard du milieu amplificateur (1, 1ᵢ).

## Patentansprüche

1. Umschaltverfahren einer Laserquelle (100) in Wellenlängen mit einer externen Aushöhlung (2, 2ᵢ) mit Bragg-Gitter (5, 5ᵢ) auf Lichtleitfaser (4, 4ᵢ), **dadurch gekennzeichnet, dass** das besagte Verfahren aus Folgendem besteht:
- räumliche Umschaltung in der externen Aushöhlung (2, 2ᵢ) einer Vielzahl von jeder ein unterschiedliches Bragg-Gitter (5, 5ᵢ) tragenden Lichtleitfasern (4, 4ᵢ).

2. Umschaltverfahren einer Laserquelle (100) in Wellenlängen gemäß Anspruch 1, **dadurch gekennzeichnet, dass** das besagte Verfahren ebenfalls aus Folgendem besteht:
- das Verstärkermedium (1, 1ᵢ), das die externe Aushöhlung (2, 2ᵢ) begrenzt, mittels einer intermediären Lichtleitfaser (6, 6ᵢ) mit den Lichtleitfasern (4, 4ᵢ) koppeln.

3. Umschaltverfahren einer Laserquelle (100) in Wellenlängen gemäß Anspruch 2, **dadurch gekennzeichnet, dass** das besagte Verfahren ebenfalls aus Folgendem besteht:
- Begrenzung einer Vielzahl externer Aushöhlungen (2ᵢ) mit Bragg-Gitter (5ᵢ) mittels einer Vielzahl von Verstärkermedien (1ᵢ) und
- simultanes Ausgeben eines Laserstrahlenbündels durch die externe Aushöhlung (2ᵢ).

4. Umschaltverfahren einer Laserquelle (100) in Wellenlängen gemäß Anspruch 2 und 3, **dadurch gekennzeichnet, dass** das besagte Verfahren ebenfalls aus Folgendem besteht:
- Koppeln jeder intermediären Lichtleitfaser (6, 6ᵢ) mit den die Bragg-Gitter (5, 5ᵢ) tragenden Lichtleitfasern (4, 4ᵢ) durch Ausrüsten der Enden gegenüber den Lichtleitfasern mit einem Abschnitt aus reinem Silizium und einem Abschnitt mit Indexgradienten (13), wobei die Abschnitte von bestimmter Länge (Ls, Lin) sind.

5. Umschaltverfahren einer Laserquelle (100) in Wellenlängen gemäß Anspruch 2 bis 4, **dadurch gekennzeichnet, dass** das besagte Verfahren ebenfalls aus Folgendem besteht:
- eine den Index anpassende Flüssigkeit (12) zwischen jeder intermediären Lichtleitfaser (6, 6ᵢ) und den die Bragg-Gitter (5, 5ᵢ) tragenden Lichtleitfasern (4, 4ᵢ) einfügen.

6. Umschaltvorrichtung einer Laserquelle (100) in Wellenlängen mit einer externen Aushöhlung (2, 2ᵢ) mit Bragg-Gitter (5, 5ᵢ) auf Lichtleitfaser (6, 6ᵢ), **dadurch gekennzeichnet, dass** die besagte Vorrichtung Folgendes umfasst:
- einen räumlichen Umschalter (3) zum Umschalten einer Vielzahl von jeder ein unterschiedliches Bragg-Gitter (5, 5ᵢ) tragenden Lichtleitfasern (6, 6ᵢ) in der externen Aushöhlung (2, 2ᵢ).

7. Umschaltvorrichtung einer Laserquelle (100) in Wellenlängen gemäß Anspruch 6, **dadurch gekennzeichnet, dass** die besagte Vorrichtung darüber hinaus Folgendes umfasst:
- ein Verstärkermedium (1, 1ᵢ) mit einer Vorderseite (7) und einer Hinterseite (8), wobei die Hinterseite (8) mit einem Bragg-Gitter (5, 5ᵢ) die externe Aushöhlung (2, 2ᵢ) begrenzt und
- einer zwischen der Vorderseite (7) des Verstärkermediums (1, 1ᵢ) und einer ein Bragg-Gitter (5, 5ᵢ) tragenden Lichtleitfaser (4, 4ᵢ) intermediären Lichtleitfaser (6, 6ᵢ) zum Koppeln des Verstärkermediums (1, 1ᵢ) an die ein Bragg-Gitter (5, 5ᵢ) tragende Lichtleitfaser (4, 4ᵢ).

8. Umschaltvorrichtung einer Laserquelle (100) in Wellenlängen gemäß Anspruch 7, **dadurch gekennzeichnet, dass** die besagte Vorrichtung darüber hinaus Folgendes umfasst:
- eine Vielzahl von eine Vielzahl von externen Aushöhlungen (2ᵢ) mit Bragg-Gitter (5ᵢ) auf Lichtleitfaser (4ᵢ) begrenzenden Verstärkermedien (1ᵢ) zum simultanen Ausgeben der Laserstrahlenbündel auf den unterschiedlichen Lichtleitfasern (4ᵢ) und
- eine Vielzahl von intermediären Lichtleitfasern (6, 6ᵢ), wobei jede intermediäre Lichtleitfaser (6, 6ᵢ) ein Verstärkermedium (1, 1ᵢ) mit einer ein Bragg-Gitter (5, 5ᵢ) tragenden Lichtleitfaser (4, 4ᵢ) koppelt.

9. Umschaltvorrichtung einer Laserquelle (100) in Wellenlängen gemäß Anspruch 7 und 8, **dadurch gekennzeichnet, dass** die besagte Vorrichtung darüber hinaus Folgendes umfasst:
- eine die Reflektivität des Diopters (11) eines der Enden jeder ein Bragg-Gitter (5, 5ᵢ) tragenden Lichtleitfaser (4, 4ᵢ) begrenzende Behandlung, wobei das besagte Ende sich auf der gegenüberliegenden Seite der intermediären Lichtleitfaser (6, 6i) befindet, und
- die Laserstrahlenbündel werden auf der Hinterseite (8) der Verstärkermedien ausgegeben (1, 1ᵢ).

10. Umschaltvorrichtung einer Laserquelle (100) in Wellenlängen gemäß Anspruch 7 bis 9, **dadurch gekennzeichnet, dass**:
- jede intermediäre Lichtleitfaser (6, 6ᵢ) und jede ein Bragg-Gitter (5, 5ᵢ) tragende Lichtleitfaser (4, 4ᵢ) gespalten sind.

11. Umschaltvorrichtung einer Laserquelle (100) in Wellenlängen gemäß Anspruch 7 bis 9, **dadurch gekennzeichnet, dass**:
- die gegenüberliegenden Enden jeder intermediären Lichtleitfaser (6, 6ᵢ) und jeder ein Bragg-Gitter (5, 5ᵢ) tragenden Lichtleitfaser (4, 4ᵢ) mit einer aus einem Abschnitt aus reinem Silizium und einem Abschnitt mit Indexgradienten gebildeten Mikrooptik (13) ausgerüstet sind, wobei die besagten Abschnitte von bestimmter Länge (Ls, Lin) sind, um die Lichtleitfasern (6ᵢ, 4ᵢ) untereinander zu koppeln.

12. Umschaltvorrichtung einer Laserquelle (100) in Wellenlängen gemäß Anspruch 10 und 11, **dadurch gekennzeichnet, dass** die besagte Vorrichtung darüber hinaus Folgendes umfasst:
- eine den Index zwischen jeder intermediären Lichtleitfaser (6, 6ᵢ) und einer ein Bragg-Gitter (5, 5ᵢ) tragenden Lichtleitfaser (4, 4ᵢ) anpassende Flüssigkeit (12).

13. Umschaltvorrichtung einer Laserquelle (100) in Wellenlängen gemäß Anspruch 7 bis 12, **dadurch gekennzeichnet, dass**:
- eines der Enden jeder intermediären Lichtleitfaser (6, 6ᵢ) mit einem Abschnitt aus reinem Silizium und einem Abschnitt mit Indexgradient ausgerüstet ist, wobei die besagten Abschnitte von bestimmter Länge sind, um die intermediäre Lichtleitfaser (6, 6ᵢ) mit den Verstärkermedien (1, 1ᵢ). zu koppeln.

14. Umschaltvorrichtung einer Laserquelle (100) in Wellenlängen gemäß Anspruch 13, **dadurch gekennzeichnet, dass**:
- ein hyperbolisches Profil am Ende der intermediären Lichtleitfaser (6, 6ᵢ) gegenüber dem Verstärkermedium (1, 1ᵢ) gegeben wird.

## Claims

1. A method of wavelength switching a laser source (100) comprising an external cavity (2, 2ᵢ) with a Bragg grating (5, 5ᵢ) in an optical fiber (4, 4ᵢ), the method being **characterized in that** it consists in:
· performing space division switching in the external cavity (2, 2ᵢ) between a plurality of optical fibers (4, 4ᵢ) each having a different Bragg grating (5, 5ᵢ).

2. A method of wavelength switching a laser source (100) according to claim 1, **characterized in that** said method also consists in:
· coupling the amplifying medium (1, 1ᵢ) which defines the external cavity (2, 2ᵢ) to the optical fibers (4, 4ᵢ) by means of an intermediate optical fiber (6, 6ᵢ).

3. A method of wavelength switching a laser source (100) according to claim 2, **characterized in that** said method also consists in:
· defining a plurality of external cavities (2ᵢ) having Bragg gratings (5ᵢ) by means of a plurality of amplifying media (1ᵢ); and
· simultaneously emitting one laser beam per external cavity (2ᵢ).

4. A method of wavelength switching a laser source (100) according to claim 2 or 3, **characterized in that** said method also consists in:
· coupling each intermediate optical fiber (6, 6ᵢ) with the optical fibers (4, 4ᵢ) carrying the Bragg gratings (5, 5ᵢ) by fitting the facing ends of the optical fibers with respective pure silica segments and respective graded index segments (13), said segments being of determined lengths (Ls, Lin).

5. A method of wavelength switching a laser source (100) according to any one of claims 2 to 4, **characterized in that** said method also consists:
· in inserting an index-matching liquid (12) between each intermediate optical fiber (6, 6ᵢ) and the optical fibers (4, 4ᵢ) carrying the Bragg gratings (5, 5ᵢ).

6. Apparatus for wavelength switching a laser source (100) comprising an external cavity (2, 2ᵢ) with a Bragg grating (5, 5ᵢ) in an optical fiber (6, 6ᵢ), the apparatus being **characterized in that** it comprises:
· a space division switch (3) in the external cavity (2, 2ᵢ) for switching between a plurality of optical fibers (6, 6ᵢ) each carrying a different Bragg grating (5, 5ᵢ).

7. Apparatus for wavelength switching a laser source (100) according to claim 6, **characterized in that** said apparatus further comprises:
· an amplifying medium (1, 1ᵢ) having a front face (7) and a rear face (8), the rear face (8) co-operating with a Bragg grating (5, 5ᵢ) to define the external cavity (2, 2ᵢ) ; and
· an intermediate optical fiber (6, 6ᵢ) between the front face (7) of the amplifying medium (1, 1ᵢ) and an optical fiber (4, 4ᵢ) carrying a Bragg grating (5, 5ᵢ) to couple the amplifying medium (1, 1ᵢ) to the optical fiber (4, 4ᵢ) carrying the Bragg grating (5, 5ᵢ).

8. Apparatus for wavelength switching a laser source according to claim 7, **characterized in that** said apparatus further comprises:
· a plurality of amplifying media (1ᵢ) defining a plurality of external cavities (2ᵢ) with Bragg gratings (5ᵢ) in optical fibers (4ᵢ) to emit laser beams simultaneously from different optical fibers (4ᵢ); and
· a plurality of intermediate optical fibers (6, 6ᵢ), each intermediate optical fiber (6, 6ᵢ) coupling an amplifying medium (1, 1ᵢ) to an optical fiber (4, 4ᵢ) carrying a Bragg grating (5, 5ᵢ).

9. Apparatus for wavelength switching a laser source according to claim 7 or 8, **characterized in that** said apparatus further comprises:
· treatment limiting the reflectivity of the optical surface (11) at one of the ends of each optical fiber (4, 4ᵢ) carrying a Bragg grating (5, 5ᵢ), said end facing away from the intermediate optical fiber (6, 6ᵢ); and
· the laser beams are emitted from the rear faces (8) of the amplifying media (1, 1ᵢ).

10. Apparatus for wavelength switching a laser source according to any one of claims 7 to 9, **characterized in that**:
· each intermediate optical fiber (6, 6ᵢ) and each optical fiber (4, 4ᵢ) carrying a Bragg grating (5, 5ᵢ) is cleaved.

11. Apparatus for wavelength switching a laser source according to any one of claims 7 to 9, **characterized in that**:
· the facing ends of each intermediate optical fiber (6, 6ᵢ) and of each optical fiber (4, 4ᵢ) carrying a Bragg grating (5, 5ᵢ) are fitted with respective micro-optical systems (13) each comprising a segment of pure silica and a graded index segment, said segments being of determined lengths (Ls, Lin) to couple the optical fibers (6ᵢ, 4ᵢ) together.

12. Apparatus for wavelength switching a laser source according to claim 10 or 11, **characterized in that** said apparatus further comprises:
· an index-matching liquid (12) between each intermediate optical fiber (6, 6ᵢ) and an optical fiber (4, 4ᵢ) carrying a Bragg grating (5, 5ᵢ).

13. Apparatus for wavelength switching a laser source according to any one of claims 7 to 12, **characterized in that**:
· one of the ends of each intermediate optical fiber (6, 6ᵢ) is fitted with a segment of pure silica and with a graded index segment, said segments being of determined lengths, to couple said intermediate optical fiber (6, 6ᵢ) to one of the amplifying media (1, 1ᵢ).

14. Apparatus for wavelength switching a laser source according to claim 13, **characterized in that**:
· a hyperbolic profile is given to the end of the intermediate optical fiber (6, 6ᵢ) facing the amplifying medium (1, 1ᵢ).
